# DEMANDE DE BREVET EUROPEEN

(11) **EP 4 075 515 A1**
(43) Date de publication de la demande: **19.10.2022**
(21) Numéro de dépôt: 22167326.2
(22) Date de dépôt: 08.04.2022
(51) Int. Cl.: H01L 29/778, H01L 29/417, H01L 29/872, H01L 27/06, H01L 29/20

(54) **DISPOSITIF BIDIRECTIONNEL POURVU D'UN EMPILEMENT DE DEUX TRANSISTORS À HAUTE MOBILITÉ ÉLECTRONIQUE CONNECTÉS TÊTE-BÊCHE**

(30) Priorité: 14.04.2021 FR 2103832
(71) Demandeur: Exagan, 38040 Grenoble Cedex 9 (FR); STMicroelectronics International N.V., 1228 Plan-les-Ouates, Geneva (CH)
(72) Inventeur: NONGAILLARD, Matthieu, 38000 GRENOBLE (FR); OHEIX, Thomas, 38100 GRENOBLE (FR)
(74) Mandataire: Cabinet Beaumont

(57) **Abrégé**

L'invention concerne un dispositif (100) qui comprend un empilement de deux transistors à haute mobilité électronique, dits premier (200) et deuxième (300) transistor, séparés par une couche isolante (400) et pourvus chacun d'un empilement de couches semi-conductrices dits, respectivement, premier empilement et deuxième empilement, le premier et le deuxième empilement comprenant chacun, à partir de la couche isolante (400) vers, respectivement, une première face (100a) et une deuxième face (100b), une couche barrière (201, 301) et une couche canal (202, 302), le premier (200) et le deuxième (300) transistor comprenant, respectivement, un premier jeu d'électrodes et un deuxième jeu d'électrodes, le premier et le deuxième jeu d'électrodes comprenant chacun une électrode de source (204, 304), une électrode de drain (205, 305) et une électrode de grille (206, 306) qui sont agencées de sorte que le premier (200) et le deuxième (300) transistor soient électriquement connectés tête-bêche.

## Description

### DOMAINE DE L'INVENTION

L'invention se rapporte au domaine de l'électronique, et notamment de l'électronique de puissance. Plus particulièrement, la présente invention concerne un dispositif pourvu de deux transistors à haute mobilité électronique.

Le dispositif selon la présente invention est notamment agencé pour permettre une meilleure intégration des deux transistors à haute mobilité électronique.

L'agencement prévu dans la présente invention permet à cet égard l'obtention d'un dispositif bidirectionnel et compact.

### ARRIERE PLAN TECHNOLOGIQUE DE L'INVENTION

Les transistors à haute mobilité électronique (« HEMT » ou « High Electron Mobility Transistor » selon la terminologie Anglo-Saxonne), bien connus de l'homme du métier, sont aujourd'hui largement mis en œuvre dans le domaine des hyperfréquences et celui des commutateurs pour les convertisseurs en électronique de puissance.

A cet égard, ces transistors HEMT sont généralement élaborés à partir de couches de matériaux semi-conducteur III-V et plus particulièrement des matériaux semi-conducteur III-N.

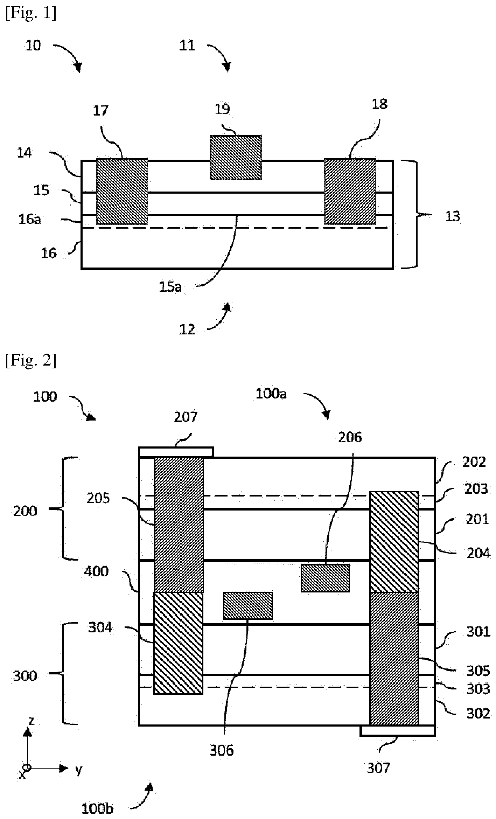

Notamment, la figure 1 représente un transistor HEMT 10 connu de l'état de la technique. Ce transistor HEMT 10 est pourvu d'un empilement 13 qui comprend, d'une face avant 11 vers une face arrière 12, une couche d'isolant 14, une couche barrière 15 et une couche canal 16 apte à former une couche de conduction 16a sous forme d'une couche de gaz électronique à deux dimensions. En particulier, la couche de conduction 16a s'étend dans la couche canal 16 à partir d'une interface 15a, formée entre la couche barrière 15 et ladite couche canal 16.

Les matériaux semi-conducteur III-V choisis pour former la couche barrière 15 et/ou la couche canal 16 peuvent comprendre du nitrure de gallium (GaN), du nitrure d'aluminium (AlN), des alliages ternaires AlxGa1-xNx, de l'arséniure de gallium (GaAs), des alliages de ternaires d'AlGaAs ou d'InGaAs. Par exemple, la couche barrière 15 et la couche canal 16 peuvent comprendre, respectivement, un composé d'AlGaN et du GaN. La couche d'isolant 14 peut comprendre un matériau diélectrique et notamment du dioxyde de silicium (SiO2) ou nitrure de silicium (Si3N4).

Le transistor HEMT 10 comprend également une électrode de source 17 et une électrode de drain 18 en contact électrique avec la couche de conduction 16a. Plus particulièrement, l'électrode de source 17 et l'électrode de drain 18 débouchent par la face avant 11, et traversent la couche barrière 15 afin d'atteindre l'interface 15a et contacter électriquement la couche de conduction 16a. L'électrode de source 17 et l'électrode de drain 18 peuvent traverser partiellement ou intégralement la couche de conduction 16a. L'électrode de source 17 et l'électrode de drain 18 peuvent comprendre une espèce métallique, par exemple de l'aluminium, remplissant des tranchées formées dans l'empilement 13.

Le transistor HEMT 10 comprend également une électrode de grille 19 destinée à se voir imposer une tension Vg permettant de contrôler l'état de la couche de conduction 16a. Notamment, dès lors que la différence de potentiel électrique entre l'électrode de grille 19 et l'électrode de source 17, notée Vg-Vs, est supérieure à une tension de seuil Vth caractéristique du transistor HEMT 10, ledit transistor est dans l'état passant. A contrario, dès lors que Vg-Vs est inférieure à Vth, le transistor HEMT 10 est dans l'état non-passant, et se comporte donc comme un interrupteur ouvert.

Aussi, dépendamment de la valeur de la tension de seuil Vth, et plus particulièrement de son signe, un transistor HEMT peut être en mode déplétion (« normally on » selon la terminologie Anglo-Saxonne) si sa tension de seuil Vth est négative, ou en mode enrichissement (« normally off » selon la terminologie Anglo-Saxonne) si sa tension de seuil Vth est positive.

Un tel transistor à haute mobilité électronique présente toutefois une résistivité Ron (Ron étant la résistance drain/source à l'état passant) à l'état passant qui limite l'intensité du courant susceptible de circuler dans la couche de conduction.

A cet égard, les principaux paramètres influençant la résistivité Ron sont :
- la résistance surfacique de la couche canal ;
- la résistance des contacts entre la couche de conduction et les électrodes de source et de drain ;
- les résistivités électriques des métaux de routage des puces ;
- les résistances électriques induites dans l'assemblage final dans lequel est intégré le transistor à haute mobilité électronique.

Il est par ailleurs des situations, notamment dans le domaine de la conversion et/ou du stockage d'énergie, pour lesquelles une bidirectionnalité des transistors HEMT peut être requise. Toutefois, de tels transistors bidirectionnels, à moins d'occuper une surface relativement importante, présentent une résistivité à l'état passant Ron trop élevée.

Un but de la présente invention est donc de proposer un dispositif électronique bidirectionnel pourvu de transistors à haute mobilité électronique plus compact et présentant une résistivité à l'état passant raisonnable au regard des dispositifs connus de l'état de la technique.

Un autre but de la présente invention est de proposer un dispositif électronique bidirectionnel susceptible de fonctionner à de forte tensions électriques et notamment supérieures à 600 V.

### BREVE DESCRIPTION DE L'INVENTION

Les buts de la présente invention sont, au moins en partie, atteints par un dispositif qui comprend un empilement de deux transistors à haute mobilité électronique, dits premier et deuxième transistor, séparés par une couche isolante et pourvus chacun d'un empilement de couches semi-conductrices dits, respectivement, premier empilement et deuxième empilement, le premier et le deuxième empilement comprenant chacun, à partir de la couche isolante vers, respectivement, une première face et une deuxième face, une couche barrière et une couche canal, le premier et le deuxième transistor comprenant, respectivement, un premier jeu d'électrodes et un deuxième jeu d'électrodes, le premier et le deuxième jeu d'électrodes comprenant chacun une électrode de source, une électrode de drain et une électrode de grille qui sont agencées de sorte que le premier et le deuxième transistor soient électriquement connectés tête-bêche.

La connexion tête-bêche des deux transistors HEMT permet ainsi de former un dispositif compact et bidirectionnel. La mise en œuvre de deux transistors HEMT, plutôt qu'un unique transistor HEMT bidirectionnel, permet également de limiter la résistivité Ron.

Ce dispositif n'implique pas de redimensionnement majeur des transistors HEMT.

Selon un mode de mise en œuvre, ledit dispositif comprend deux terminaux dits, respectivement, premier terminal et deuxième terminal, le premier terminal étant en contact électrique avec l'une des électrodes de drain du premier jeu et de source du deuxième jeu, et le deuxième terminal étant en contact électrique avec l'une des électrodes de drain du deuxième jeu et de source du premier jeu.

Selon un mode de mise en œuvre, le premier terminal comprend un premier plot reposant sur l'une ou l'autre de la première face et de la deuxième face, et le deuxième terminal comprend un deuxième plot reposant sur l'une ou l'autre de la première et de la deuxième face.

Selon un mode de mise en œuvre, l'électrode de grille du premier jeu et l'électrode de grille du deuxième jeu sont agencées pour contrôler le passage, respectivement du premier transistor et du deuxième transistor, de l'un d'un état passant et d'un état non passant vers l'autre de ces deux états.

Selon un mode de mise en œuvre, la couche canal du premier transistor, lorsque ce dernier est dans un état passant, est apte à former une couche de conduction, dite première couche de conduction, et dans laquelle un courant est susceptible de circuler du premier terminal vers le deuxième terminal, et la couche canal du deuxième transistor, lorsque ce dernier est dans un état passant, est apte à former une couche de conduction, dite deuxième couche de conduction, et dans laquelle un courant est susceptible de circuler du deuxième terminal vers le premier terminal.

Selon un mode de mise en œuvre, la connexion électrique tête-bêche du premier et du deuxième transistor comprend une connexion de l'électrode de drain du premier jeu avec l'électrode de source du deuxième jeu et de l'électrode de source du premier jeu avec l'électrode de drain du deuxième jeu.

Selon un mode de mise en œuvre, la connexion entre l'électrode de drain du premier jeu et l'électrode de source du deuxième jeu est directe de sorte que chacune de ces deux électrodes est au même potentiel électrique, et la connexion entre l'électrode de source du premier jeu et l'électrode de drain du deuxième jeu est directe de sorte que chacune de ces deux électrodes est au même potentiel électrique.

Selon un mode de mise en œuvre, l'électrode de source du premier jeu est confondue avec l'électrode de drain du deuxième jeu, et l'électrode de drain du premier jeu est confondue avec l'électrode de source du deuxième jeu.

Selon un mode de mise en œuvre, une diode, dite première diode, est intercalée entre l'électrode de source du premier jeu et l'électrode de drain du deuxième jeu, ladite première diode étant agencée pour permettre la circulation d'un courant du premier terminal vers le deuxième terminal, et une autre diode, dite deuxième diode, est intercalée entre l'électrode de drain du premier jeu avec l'électrode de source du deuxième jeu, ladite deuxième diode étant agencée pour permettre la circulation d'un courant du deuxième terminal vers le premier terminal.

La mise en œuvre de la première et de la deuxième diode rend ainsi possible d'utiliser le dispositif pour des hautes tensions, et notamment supérieures à 600 V.

Selon un mode de mise en œuvre, la première diode et la deuxième diode sont formées, respectivement, dans le premier empilement et le deuxième empilement.

Selon un mode de mise en œuvre, la couche isolante comprend un matériau diélectrique, avantageusement, du dioxyde de silicium ou du nitrure de silicium.

Selon un mode de mise en œuvre, ledit dispositif comprend des plots, dits premier plot grille et deuxième plot grille, disposés, respectivement, sur la première face et la deuxième face, le premier plot grille contactant électriquement l'électrode de grille du premier jeu, et le deuxième plot grille contactant électriquement l'électrode de grille du deuxième jeu.

Selon un mode de mise en œuvre, le premier et le deuxième empilement sont essentiellement identiques.

Selon un mode de mise en œuvre, le premier et le deuxième transistor présentent une tension de seuil identique.

Selon un mode de mise en œuvre, les deux couches canal comprennent du GaN et les couches barrière comprennent un alliage ternaire d'AlGaN.

### BREVE DESCRIPTION DES DESSINS

D'autres caractéristiques et avantages de l'invention ressortiront de la description détaillée qui va suivre en référence aux figures annexées sur lesquelles :
La figure 1 est une représentation schématique d'un transistor HEMT connu de l'état de la technique, notamment, le transistor HEMT est représenté selon un plan de coupe perpendiculaire à la face avant ;
La figure 2 est une représentation schématique d'un dispositif, selon un plan de coupe passant par la zone active dudit dispositif, conforme à un premier mode de réalisation de la présente invention ;
La figure 3 est une représentation schématique d'un dispositif, selon un plan de coupe en dehors de la zone active, conforme au premier mode de réalisation de la présente invention ;
La figure 4 est une représentation illustrant le positionnement déporté du premier plot grille permettant de connecter électriquement l'électrode de grille du dispositif de la figure 3 selon une vue par la première face dudit dispositif ;
La figure 5 est une représentation schématique du dispositif de la figure 2 lorsque le premier transistor est dans l'état passant et le deuxième transistor dans l'état non passant, la ligne fléchée représentant la circulation du courant selon le premier sens ;
La figure 6 est une représentation schématique du dispositif de la figure 2 lorsque le premier transistor est dans l'état non passant et le deuxième transistor dans l'état passant, la ligne fléchée représentant la circulation du courant selon le deuxième sens ;
La figure 7 est une représentation schématique d'un dispositif, selon un plan de coupe passant par la zone active dudit dispositif, conforme à un deuxième mode de réalisation de la présente invention ;
La figure 8 est une représentation schématique d'un dispositif, selon un plan de coupe passant par la zone active dudit dispositif, conforme au deuxième mode de réalisation de la présente invention et pour lequel la première et la deuxième diode sont réalisées dans, respectivement, le premier empilement et le deuxième empilement.

### DESCRIPTION DETAILLEE DE L'INVENTION

Il est entendu que les différentes figures présentées en relation avec la présente description ne sont données qu'à titre d'illustration et ne limitent en aucune manière l'invention. Il est notamment clair que les échelles ou dimensions relatives peuvent ne pas être respectées.

Dans toute la description, il est admis qu'une couche ou une interface est généralement plane et s'étend selon un plan parallèle au plan (0, x, y) du repère orthonormé (0, x, y, z). Par ailleurs, dès qu'il est fait référence à une représentation selon un plan de coupe, ce dernier est perpendiculaire à l'ensemble des plans formés par les couches, et plus particulièrement perpendiculaire au plan (0, x, y). Il est également entendu que, dès lors qu'il est fait référence à un empilement de couches, ces dernières sont empilées selon la direction z du repère orthonormé (0, x, y, z).

L'invention concerne un dispositif formé par deux transistors à haute mobilité électronique (ci-après « Transistor HEMT ») dits, respectivement, premier transistor et deuxième transistor. Ces derniers comprennent chacun un empilement de couches semi-conductrices dits respectivement, premier empilement et deuxième empilement. En particulier, le premier empilement et le deuxième empilement sont séparés par une couche isolante et s'étendent de ladite couche isolante vers, respectivement, une première face et une deuxième face du dispositif. Plus particulièrement, chaque empilement comprend, depuis la couche isolante, une couche barrière et une couche canal.

Le premier empilement et le deuxième empilement comprennent également chacun un jeu d'électrodes dits, respectivement, premier jeu et deuxième jeu. Chaque jeu d'électrodes est notamment pourvu d'une électrode de source, d'une électrode de drain et d'une électrode de grille qui sont agencées de sorte que le premier transistor et le deuxième transistor soient connectés tête-bêche (« head to tail » selon la terminologie Anglo-Saxonne).

Le dispositif peut également comprendre deux terminaux dits, respectivement, premier terminal et deuxième terminal (ces derniers forment des points de connexion), et entre lesquels un courant est susceptible de circuler soit dans le premier transistor soit dans le deuxième transistor.

Notamment, le premier terminal peut être en contact électrique avec l'une des électrodes de drain du premier jeu ou de source du deuxième jeu, tandis que le deuxième terminal peut être en contact électrique avec l'une des électrodes de drain du deuxième jeu ou de source du premier jeu.

Un tel agencement forme un dispositif à la fois compact et bidirectionnel.

Par « connectés tête-bêche », on entend deux transistors HEMT connectés selon des polarités opposées. Plus particulièrement, selon les termes de la présente invention, deux transistors HEMT sont montés tête-bêche dès lors que l'électrode de source de l'un des transistors est électriquement connectée avec l'électrode de drain de l'autre des transistors. En d'autres termes, l'électrode de source du premier transistor est connectée avec l'électrode de drain du deuxième transistor tandis que l'électrode de drain du premier transistor est connectée avec l'électrode de source du deuxième transistor.

Par « dispositif bidirectionnel », on entend un dispositif agencé pour laisser passer le courant entre deux de ses terminaux selon deux directions opposées. Notamment, selon les termes de la présente invention, le premier transistor, dès lors qu'il est dans un état passant, autorise la circulation d'un courant dans sa couche canal du premier terminal vers le deuxième terminal (selon un premier sens). De manière équivalente, le deuxième transistor, dès lors qu'il est dans un état passant, autorise la circulation d'un courant dans sa couche canal du deuxième terminal vers le premier terminal (selon un deuxième sens opposé au premier sens).

Par ailleurs, pour un transistor HEMT donné, le passage d'un ou l'autre de l'état passant et de l'état non passant vers l'autre de ces deux états est contrôlé par l'électrode de grille du transistor concerné. Plus particulièrement, ce contrôle est exécuté en imposant une tension Vg à l'électrode de grille. Notamment, dès lors que la différence de potentiel Vg-Vs entre l'électrode de grille et l'électrode de source du transistor HEMT est supérieure à sa tension de seuil Vth, ledit transistor est dans l'état passant et se comporte comme un fil conducteur. A contrario, dès lors que la différence de potentiel Vg-Vs est inférieure à la tension de seuil, le transistor HEMT est dans un état non passant et se comporte comme un interrupteur ouvert.

La figure 2 est une représentation schématique d'un dispositif 100 selon un premier mode de réalisation de la présente invention.

La description qui suit (relative au premier mode de réalisation) sera limitée à un premier terminal en contact électrique avec l'électrode de drain du premier jeu et à un deuxième terminal en contact électrique avec l'électrode de drain du deuxième jeu. L'homme du métier, sur la base de ses connaissances générales et de la présente description, pourra généraliser les concepts décrits et ainsi considérer d'autres agencements relatifs au premier terminal et au deuxième terminal.

Le dispositif 100 comprend notamment deux transistors à haute mobilité électroniques (« Transistor HEMT ») dits, respectivement, premier transistor 200 et deuxième transistor 300. En particulier, le dispositif 100 comprend d'une première face 100a vers une deuxième face 100b, le premier transistor 200, une couche isolante 400 et le deuxième transistor 300.

La couche isolante 400 peut comprendre un matériau diélectrique, avantageusement, du dioxyde de silicium ou du nitrure de silicium

Le premier transistor 200 et le deuxième transistor 300 comprennent chacun un empilement de couches semi-conductrices dits, respectivement, premier empilement et deuxième empilement.

Chaque empilement de couches semi-conductrices peut notamment comprendre des matériaux semi-conducteurs du groupe III-V, et plus particulièrement des matériaux semi-conducteurs du groupe III-N. Les matériaux semi-conducteurs du groupe III-V pourront notamment être choisis parmi le nitrure de gallium (GaN), le nitrure d'aluminium (AlN) et leurs alliages ternaires AlxGa1-xN, ou parmi l'arséniure de gallium (GaAs) et ses composés (AlGaAs, InGaAs).

Chaque empilement de couches semi-conductrices comprend, depuis la couche isolante, une couche barrière et une couche canal.

Notamment, le premier empilement comprend, depuis la couche isolante 400 et vers la première face 100a, une première couche barrière 201 et une première couche canal 202.

De manière équivalente, le deuxième empilement comprend, depuis la couche isolante 400 et vers la deuxième face 100b, une deuxième couche barrière 301 et une deuxième couche canal 302.

A titre d'exemple, et selon la présente invention, une couche barrière peut comprendre un alliage ternaire d'AlxGa1-xN, tandis qu'une couche canal peut comprendre du GaN.

Par ailleurs, une couche barrière peut présenter une épaisseur comprise entre 1 nm et 100 nm.

Une couche canal peut présenter une épaisseur comprise entre 10 nm et 2µm.

Le premier et le deuxième empilement peuvent être essentiellement identiques.

Un empilement de couches semi-conductrices, selon les termes de la présente invention, est apte à former une couche de gaz d'électrons à deux dimensions (2DEG pour « 2-dimensional electron gaz ») qui constitue une couche de conduction.

La couche de conduction, au sein d'un empilement de couches semi-conductrices, s'étend dans la couche canal, à partir de l'interface formée entre la couche barrière et la couche canal de l'empilement considéré. La couche de conduction est notamment susceptible d'être formée au sein d'un transistor HEMT dès lors que ce dernier se trouve dans un état passant.

Ainsi, dès lors que le premier transistor 200 est dans l'état passant, la première couche canal 202 est apte à former une première couche de conduction 203 qui s'étend dans ladite première couche canal 202, à partir d'une première interface formée entre la première couche barrière 201 et la première couche canal 202.

De manière équivalente, dès lors que le deuxième transistor 300 est dans l'état passant, la deuxième couche canal 302 est apte à former une deuxième couche de conduction 303 qui s'étend dans ladite deuxième couche canal 302, à partir d'une deuxième interface formée entre la deuxième couche barrière 301 et la deuxième couche canal 302.

Chaque transistor HEMT comprend un jeu d'électrodes pourvu d'une électrode de source, d'une électrode de drain et d'une électrode de grille.

Plus particulièrement, le premier transistor 200 comprend un des deux jeux d'électrodes dit premier jeu. Le premier jeu est pourvu d'une première électrode de source 204, d'une première électrode de drain 205 et d'une première électrode de grille 206.

De manière équivalente, le deuxième transistor 300 comprend l'autre des deux jeux d'électrodes, dit deuxième jeu. Le deuxième jeu est pourvu d'une deuxième électrode de source 304, d'une deuxième électrode de drain 305 et d'une deuxième électrode de grille 306.

La première électrode de source 204 et la première électrode de drain 205 s'étendent de la couche isolante 400 vers le premier empilement. Plus particulièrement, la première électrode de drain 205 et la première électrode de source 204 traversent pour partie le premier empilement et notamment la première couche canal 202. Ainsi, l'une et l'autre de la première électrode de drain 205 et de la première électrode de source 204 contactent électriquement la première couche canal 202 et plus particulièrement la première couche de conduction 203.

Par surcroit, la première électrode de drain 205 débouche au niveau de la première face 100a. à cet égard, le dispositif peut comprendre un plot, dit premier plot drain 207, reposant sur la première face et au contact de la première électrode de drain. Ce premier plot drain 207 forme un premier terminal du dispositif 100. Le premier plot drain comprend avantageusement un matériau semi-conducteur dopé, par exemple du silicium dopé.

La deuxième électrode de source 304 et la deuxième électrode de drain 305 s'étendent de la couche isolante 400 vers le deuxième empilement. Plus particulièrement, la deuxième électrode de drain 305 et la deuxième électrode de source 304 traversent pour partie le deuxième empilement et notamment la deuxième couche canal 302. Ainsi, l'une et l'autre de la deuxième électrode de drain 305 et de la deuxième électrode de source 304 contactent électriquement la deuxième couche canal 302 et plus particulièrement la deuxième couche de conduction 303.

Par surcroit, la deuxième électrode de drain 305 débouche au niveau de la deuxième face 100a. à cet égard, le dispositif peut comprendre un autre plot, dit deuxième plot drain 307, reposant sur la deuxième face et au contact de la deuxième électrode de drain. Ce deuxième plot drain 307 forme un deuxième terminal du dispositif. Le deuxième plot drain comprend avantageusement un matériau semi-conducteur dopé, par exemple du silicium dopé.

Selon la présente invention, le premier transistor 200 et le deuxième transistor 300 sont connectés tête-bêche. En d'autres termes, la première électrode de drain 205 contacte électriquement la deuxième électrode de source 304, tandis que la première électrode de source 204 contacte électriquement la deuxième électrode de drain 305.

Selon le premier mode de réalisation de la présente invention, le contact électrique entre une électrode source et une électrode drain est direct. Par « contact direct », on entend deux électrodes au même potentiel électrique. En d'autres termes, l'électrode de source du premier jeu est confondue avec l'électrode de drain du deuxième jeu, et l'électrode de drain du premier jeu est confondue avec l'électrode de source du deuxième jeu.

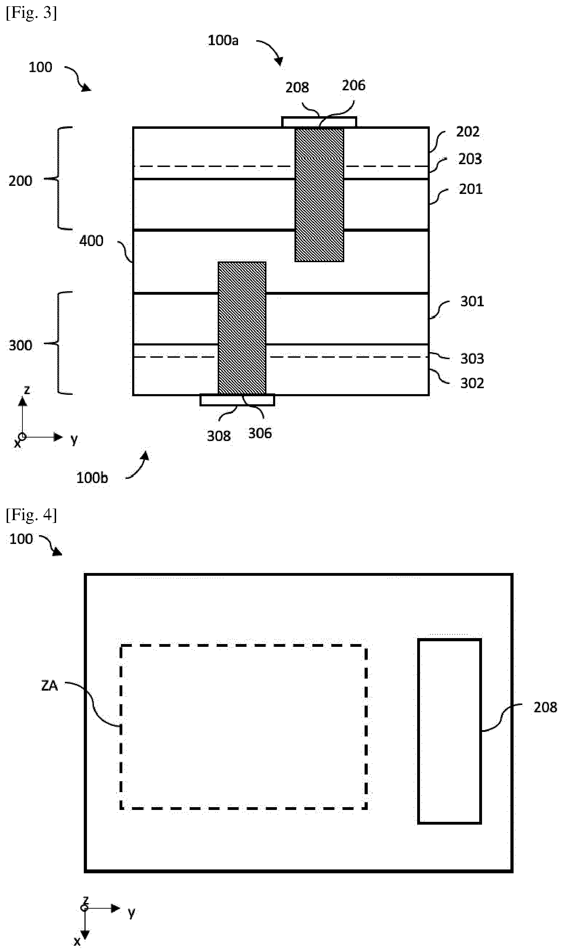

La première électrode de grille 206 et la deuxième électrode de grille 306 s'étendent chacune selon une direction perpendiculaire à la première face et dans la couche isolante 400. Plus particulièrement, la première électrode de grille 206 d'une part et la deuxième électrode de grille 306 d'autre part restent à distance au niveau d'une zone active ZA (figure 3 et figure 4) du dispositif, respectivement, du premier empilement et du deuxième empilement.

La première électrode de grille 206 et la deuxième électrode de grille 306 permettent de contrôler l'état passant ou non passant, respectivement, du premier transistor et du deuxième transistor.

Notamment, ce contrôle est exécuté en imposant un potentiel électrique Vg à l'électrode de grille, et plus particulièrement une différence de potentiel électrique DDP, noté Vg-Vs entre l'électrode de grille et l'électrode de source du transistor HEMT considéré.

Ainsi, dès lors que Vg-Vs est supérieure à une tension de seuil Vth caractéristique de chacun des transistors HEMT, ce dernier est dans l'état passant. A contrario, dès lors que Vg-Vs est inférieure à Vth, le transistor HEMT est dans l'état non-passant, et se comporte donc comme un interrupteur ouvert.

Aussi, dépendamment de la valeur de la tension de seuil Vth, et plus particulièrement de son signe, un transistor HEMT peut être en mode déplétion (« normally on » selon la terminologie Anglo-Saxonne) si sa tension de seuil Vth est négative, ou en mode enrichissement (« normally off » selon la terminologie Anglo-Saxonne) si sa tension de seuil Vth est positive.

Ainsi, les transistors HEMT susceptibles d'être considérés dans la présente invention peuvent être soit du type normalement passant ou à déplétion (transistor à haute mobilité électronique en mode déplétion) soit du type normalement bloqué ou à enrichissement (transistor à haute mobilité électronique en mode enrichissement).

Le dispositif 100 comprend également un premier plot grille 208 et un deuxième plot grille 308 disposés, respectivement, sur la première face 100a et sur la deuxième face 100b. Le premier plot grille 208 est configuré pour contacter électriquement la première électrode de grille 206. Le contact électrique est toutefois déporté de la zone active ZA (tel que représenté à la figure 3 et à la figure 4). Le deuxième plot grille 308 est configuré pour contacter électriquement la deuxième électrode de grille 306. Le contact électrique est également déporté de la zone active ZA.

Par « déporté », on entend un plot grille qui est disposé en dehors d'une zone active ZA de l'un et l'autre du premier et du deuxième transistor. A cet égard, la figure 4 est une représentation du dispositif 100 selon une vue par la première face (selon un plan parallèle au plan (0, x, y)). Les pointillés délimitent la zone active ZA au sein de laquelle tout contact entre une électrode de grille et l'une et l'autre des couches barrière et canal est évité.

Ainsi, il est possible de contrôler de manière indépendante l'état de l'un et l'autre des deux transistors HEMT.

Notamment, le contrôle du premier transistor 200 peut être exécuté en appliquant un potentiel de grille au premier plot grille 208 de manière à imposer un état passant ou un état non passant audit premier transistor 200.

De manière équivalente, le contrôle du deuxième transistor 300 peut être exécuté en appliquant un potentiel de grille au deuxième plot grille 308 de manière à imposer un état passant ou un état non passant audit deuxième transistor 300.

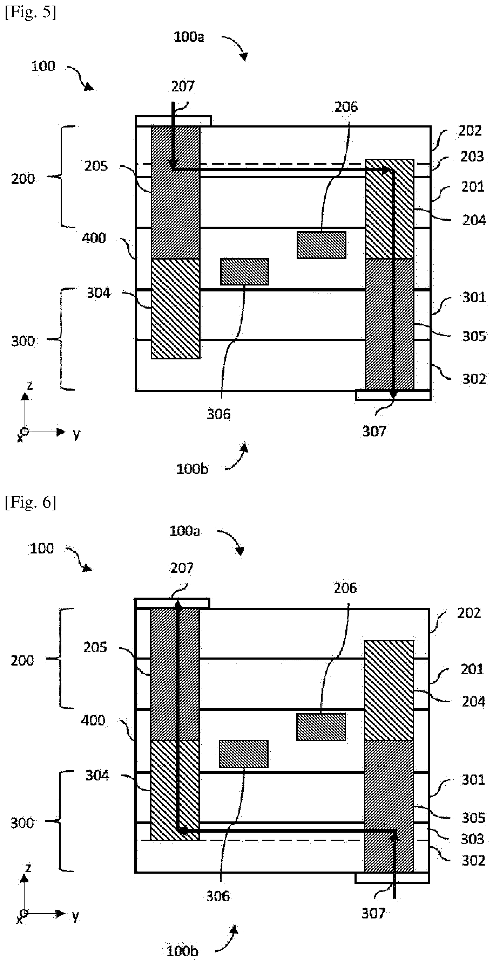

Ainsi, lorsque le premier transistor est dans l'état passant et le deuxième transistor dans l'état non passant, seul le premier transistor est susceptible de laisser passer un courant. Ce courant circule notamment, selon un premier sens (symbolisé par la ligne fléchée à la figure 5), de la première électrode de drain 205 vers la deuxième électrode de drain 305 via la première couche de conduction 203.

De manière équivalente, lorsque le deuxième transistor est dans l'état passant et le premier transistor dans l'état non passant, seul le deuxième transistor est susceptible de laisser passer un courant. Ce courant circule notamment, selon un deuxième sens opposé au premier sens (symbolisé par la ligne fléchée à la figure 6), de la deuxième électrode de drain 305 vers la première électrode de drain 205 via la deuxième couche de conduction 303.

Le dispositif 100 selon ce premier mode de réalisation du fait des empilements considérés et de l'agencement des premier et deuxième jeux reste relativement compact. Par ailleurs, la connexion tête-bêche du premier transistor avec le deuxième transistor permet de former un dispositif bidirectionnel.

Selon ce premier mode de réalisation, la première électrode de drain et la deuxième électrode de drain forment les terminaux du dispositif 100. Toutefois, et selon une variante de ce premier mode de réalisation, il aurait pu être considéré de former ces terminaux avec la première électrode de source et la deuxième électrode de source qui déboucheraient, respectivement, sur la première face et la deuxième face.

Toujours dans le cadre de cette variante, au lieu de former des plots drain, il aurait pu être considéré de former des plots source, et notamment un premier plot source sur la première face et un deuxième plot source sur la deuxième face.

Selon cette configuration, le premier plot source et le deuxième plot source seraient en contact, respectivement, avec la première électrode de source et la deuxième électrode de source.

Selon une autre variante, il aurait pu être considéré de former un premier terminal avec l'électrode de source de l'un des deux transistors HEMT, et un deuxième terminal avec l'électrode de source de l'autre des deux transistors HEMT.

L'invention concerne également un deuxième mode de réalisation qui reprend pour l'essentiel l'ensemble des termes du premier mode de réalisation.

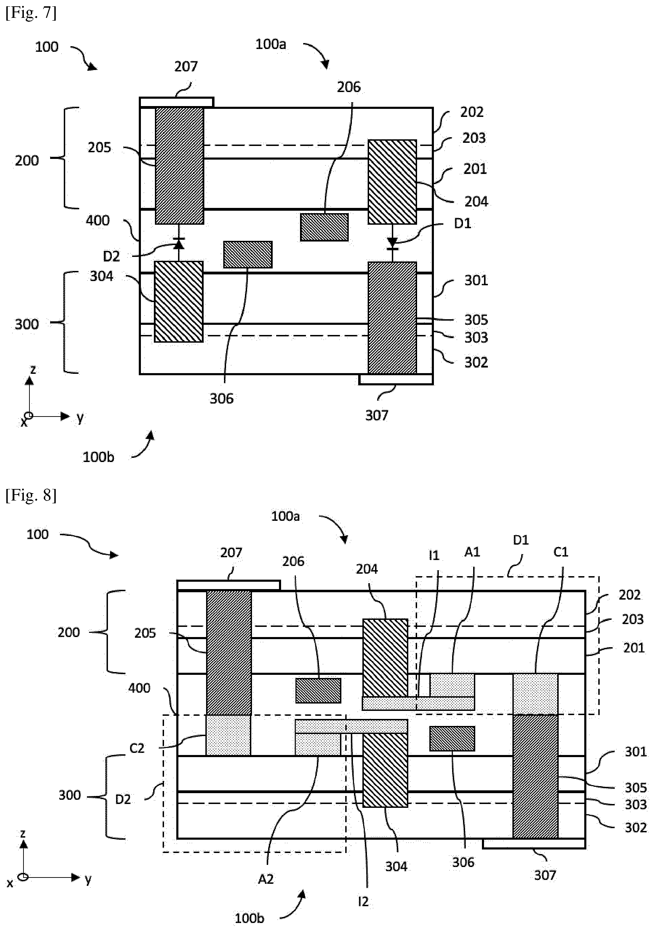

Selon ce deuxième mode de réalisation illustré à la figure 7, le dispositif comprend deux diodes dites, respectivement, première diode D1 et deuxième diode D2.

La première diode D1 est intercalée entre l'électrode de source 204 du premier jeu et l'électrode de drain 305 du deuxième jeu, tandis que la deuxième diode est intercalée entre l'électrode de drain du premier jeu et l'électrode de source du deuxième jeu.

Par ailleurs, la première diode D1 est agencée (ou polarisée) de manière à permettre la circulation d'un courant dans le premier transistor du premier terminal vers le deuxième terminal. De manière équivalente, la deuxième diode D2 est agencée (ou polarisée) de manière à permettre la circulation d'un courant dans le deuxième transistor du deuxième terminal vers le premier terminal.

La mise en œuvre de la première et de la deuxième diode permet notamment de protéger l'une et l'autre des deux électrodes de source lorsque le dispositif est mis en œuvre pour des applications haute tension, et notamment dépassant les 600 V.

Les diodes D1 et D2 permettent notamment de prévenir la polarisation de l'une et l'autre des deux électrodes de source lorsque le dispositif est soumis à une haute tension.

Les diodes D1 et D2 comprennent avantageusement chacune une diode Schottky.

Tel que représenté à la figure 8, l'anode, dite première anode A1, et la cathode, dite première cathode C1, de la première diode D1, sont connectées, respectivement, à l'électrode de source du premier jeu et à l'électrode de drain du deuxième jeu.

De manière équivalente, l'anode, dite deuxième anode A2, et la cathode, dite deuxième cathode C2, de la deuxième diode D2, sont connectées respectivement, à l'électrode de source du deuxième jeu et à l'électrode de drain du premier jeu.

De manière avantageuse, la première diode D1 et la deuxième diode D2 sont formées, respectivement, dans le premier empilement et le deuxième empilement (figure 8).

En particulier, la cathode C2 de la deuxième diode s'étend dans la couche isolante 400 et dans le deuxième empilement. Par ailleurs, la cathode C2 contacte électriquement la première électrode de drain dans la couche isolante. La cathode C2 et la première électrode de drain sont avantageusement confondues.

De manière équivalente, la cathode C1 de la première diode s'étend dans la couche isolante 400 et dans le premier empilement. Par ailleurs, la cathode C1 contacte électriquement la deuxième électrode de drain dans la couche isolante. La cathode C1 et la deuxième électrode de drain sont avantageusement confondues.

L'anode A1 de la première diode, disposée à proximité de la cathode C1, s'étend dans la couche isolante et dans le premier empilement. Une première interconnexion I1, disposée dans la couche isolante, permet de connecter l'anode A1 avec la première électrode de source.

De manière équivalente, l'anode A2 de la deuxième diode, disposé à proximité de la cathode C2, s'étend dans la couche isolante et dans le deuxième empilement. Une deuxième interconnexion I2, disposée dans la couche isolante, permet de connecter l'anode A2 avec la deuxième électrode de source.

Cette architecture permet d'obtenir un dispositif 100 compact et capable de « tenir » les tensions élevées et notamment supérieures à 600 Volt.

Le dispositif 100 selon la présente invention peut avantageusement être mis en œuvre dans des convertisseurs de tension, et notamment des convertisseurs haute tension.

Bien sûr, l'invention n'est pas limitée aux modes de réalisation décrits et on peut y apporter des variantes de réalisation sans sortir du cadre de l'invention tel que défini par les revendications.

## Revendications

1. Dispositif (100) qui comprend un empilement de deux transistors à haute mobilité électronique, dits premier (200) et deuxième (300) transistor, séparés par une couche isolante (400) et pourvus chacun d'un empilement de couches semi-conductrices dits, respectivement, premier empilement et deuxième empilement, le premier et le deuxième empilement comprenant chacun, à partir de la couche isolante (400) vers, respectivement, une première face (100a) et une deuxième face (100b), une couche barrière (201, 301) et une couche canal (202, 302), le premier (200) et le deuxième (300) transistor comprenant, respectivement, un premier jeu d'électrodes et un deuxième jeu d'électrodes, le premier et le deuxième jeu d'électrodes comprenant chacun une électrode de source (204, 304), une électrode de drain (205, 305) et une électrode de grille (206, 306) qui sont agencées de sorte que le premier (200) et le deuxième (300) transistor soient électriquement connectés tête-bêche.

2. Dispositif (100) selon la revendication 1, dans lequel ledit dispositif (100) comprend deux terminaux dits, respectivement, premier terminal et deuxième terminal, le premier terminal étant en contact électrique avec l'une des électrodes de drain (205) du premier jeu et de source (304) du deuxième jeu, et le deuxième terminal étant en contact électrique avec l'une des électrodes de drain (305) du deuxième jeu et de source (204) du premier jeu.

3. Dispositif (100) selon la revendication 2, dans lequel le premier terminal comprend un premier plot reposant sur l'une ou l'autre de la première face (100a) et de la deuxième face (100b), et le deuxième terminal comprend un deuxième plot reposant sur l'une ou l'autre de la première et de la deuxième face.

4. Dispositif (100) selon la revendication 2 ou 3, dans lequel l'électrode de grille (206) du premier jeu et l'électrode de grille (306) du deuxième jeu sont agencées pour contrôler le passage, respectivement du premier transistor (200) et du deuxième transistor (300), de l'un d'un état passant et d'un état non passant vers l'autre de ces deux états.

5. Dispositif (100) selon l'une des revendications 2 à 4, dans lequel la couche canal (202) du premier transistor (200), lorsque ce dernier est dans un état passant, est apte à former une couche de conduction, dite première couche de conduction (203), et dans laquelle un courant est susceptible de circuler du premier terminal vers le deuxième terminal, et la couche canal (302) du deuxième transistor, lorsque ce dernier est dans un état passant, est apte à former une couche de conduction, dite deuxième couche de conduction (303), et dans laquelle un courant est susceptible de circuler du deuxième terminal vers le premier terminal.

6. Dispositif (100) selon l'une des revendications 2 à 5, dans lequel la connexion électrique tête-bêche du premier et du deuxième transistor comprend une connexion de l'électrode de drain (205) du premier jeu avec l'électrode de source (304) du deuxième jeu et de l'électrode de source (204) du premier jeu avec l'électrode de drain (305) du deuxième jeu.

7. Dispositif (100) selon la revendication 6, dans lequel la connexion entre l'électrode de drain (205) du premier jeu et l'électrode de source (304) du deuxième jeu est directe de sorte que chacune de ces deux électrodes est au même potentiel électrique, et la connexion entre l'électrode de source (204) du premier jeu et l'électrode de drain (305) du deuxième jeu est directe de sorte que chacune de ces deux électrodes est au même potentiel électrique.

8. Dispositif (100) selon la revendication 7, dans lequel l'électrode de source (204) du premier jeu est confondue avec l'électrode de drain (305) du deuxième jeu, et l'électrode de drain (205) du premier jeu est confondue avec l'électrode de source (304) du deuxième jeu.

9. Dispositif (100) selon la revendication 6, dans lequel une diode, dite première diode (D1), est intercalée entre l'électrode de source (204) du premier jeu et l'électrode de drain (305) du deuxième jeu, ladite première diode (D1) étant agencée pour permettre la circulation d'un courant du premier terminal vers le deuxième terminal, et une autre diode, dite deuxième diode (D2), est intercalée entre l'électrode de drain (205) du premier jeu avec l'électrode de source (304) du deuxième jeu, ladite deuxième diode (D2) étant agencée pour permettre la circulation d'un courant du deuxième terminal vers le premier terminal.

10. Dispositif (100) selon la revendication 9, dans lequel la première diode (D1) et la deuxième diode (D2) sont formées, respectivement, dans le premier empilement et le deuxième empilement.

11. Dispositif (100) selon l'une des revendications 1 à 10, dans lequel la couche isolante (400) comprend un matériau diélectrique, avantageusement, du dioxyde de silicium ou du nitrure de silicium.

12. Dispositif (100) selon l'une des revendications 1 à 11, dans lequel ledit dispositif (100) comprend des plots, dits premier plot grille (208) et deuxième plot grille (308), disposés, respectivement, sur la première face (100a) et la deuxième face (100b), le premier plot grille (208) contactant électriquement l'électrode de grille (206) du premier jeu, et le deuxième plot grille (308) contactant électriquement l'électrode de grille (306) du deuxième jeu.

13. Dispositif (100) selon l'une des revendications 1 à 12, dans lequel le premier et le deuxième empilement sont essentiellement identiques.

14. Dispositif (100) selon l'une des revendications 1 à 13, dans lequel le premier (200) et le deuxième (300) transistor présentent une tension de seuil identique.

15. Dispositif (100) selon l'une des revendications 1 à 14, dans lequel les deux couches canal (202, 302) comprennent du GaN et les couches barrière comprennent un alliage ternaire d'AlGaN.
